# EUROPEAN PATENT APPLICATION

(11) **EP 2 410 543 A2**
(43) Date of publication of application: **25.01.2012**
(21) Application number: 11174151.8
(22) Date of filing: 15.07.2011
(51) Int. Cl.: H01G 9/20

(54) **Dye-sensitized solar cell**

(30) Priority: 22.07.2010 JP 2010164764
(71) Applicant: Nitto Denko Corporation, Osaka 567-8680 (JP)
(72) Inventor: Igarashi, Kazumasa, Osaka 567-8680 (JP); Hasegawa, Yuki, Osaka 567-8680 (JP)
(74) Representative: HOFFMANN EITLE

(57) **Abstract**

A dye-sensitized solar cell is provided, which includes a seal member that is free from swelling and degradation during prolonged sealing use and highly excellent in sealability. The dye-sensitized solar cell includes: a pair of electrode substrates (1,1') spaced a predetermined distance from each other with their electrically conductive electrode surfaces facing inward; a seal member (7) disposed along peripheries of inner surfaces of the electrode substrates to seal a space between the electrode substrates (1,1'); and an electrolyte solution (5) filled in the sealed space. The seal member (7) is

composed of a material cured by photopolymerizing the following photopolymerizable composition (A), and the electrode substrates each have a portion coated with a (meth)acryloxyalkylsilane silane coupling agent in contact with the seal member (7). The photopolymerizable composition (A)contains a hydrogenated elastomer derivative having at least one (meth)acryloyl group at at least one of its opposite molecular terminals.

## Description

### BACKGROUND OF THE INVENTION

### 1. Field of the Invention

The present invention relates to a dye-sensitized solar cell which includes a pair of electrode substrates adhesively sealed in an opposed relationship, and an electrolyte solution filled in a space between the electrode substrates. More specifically, the invention relates to a dye-sensitized solar cell including a seal member which is highly resistant to the electrolyte solution and excellent in adhesive sealability and durability.

### 2. Description of the Related Art

A dye-sensitized solar cell which includes a transparent electrically conductive substrate formed with a dye-carrying semiconductor film such as a film made of TiO₂, a counter electrode substrate and a redox-type electrolyte solution filled in a space between these substrates is promising as a less expensive next-generation solar cell because of its higher solar light conversion efficiency.

However, if a conventionally used ethylene-methacrylic acid copolymer ionomer resin is used as a sealing material for a dye-sensitized solar cell including a redox-type electrolyte solution, such as iodine or lithium iodide, filled in a space between glass substrates or plastic film substrates, it is impossible to prevent leakage of the electrolyte solution and absorption of external moisture. Therefore, the dye-sensitized solar cell of this type is poor in durability. On the other hand, epoxy resin sealing materials, urethane resin sealing materials and photo-curable acryl resin sealing materials known to be used as liquid crystal sealing materials are liable to swell with the electrolyte solution due to their polar structures. This adversely affects the structure of the dye-sensitized solar cell.

In view of this, it is proposed that a liquid epoxy resin or a silicone resin is used for sealing the electrolyte solution (see JP-A-2000-30767). Further, a sealing material containing a silane coupling agent and prepared by polymerizing an organo-hydrogen polysiloxane and a polyisoprene polymer having at least one alkenyl group in its molecule to be subjected to a hydrosilylation reaction in the presence of a hydrosilylation catalyst is proposed as a sealing material containing an elastomer more excellent in electrolyte solution resistance for the dye-sensitized solar cell (see JP-A-2004-95248).

On the other hand, a dye-sensitized solar cell including a counter electrode substrate of a metal has been proposed(see JP-A-2009-266778). With the use of a metal substrate such as titanium, tungsten, gold, silver or copper, which is per se electrically conductive, it is possible to reduce the overall weight of the cell as compared with a case in which a glass substrate is used as a counter substrate. Further, it is possible to reduce the costs by using an expensive glass substrate as only one of the substrates. The dye-sensitized solar cell proposed in JP-A-2009-266778 has excellent durability, which was confirmed by a one-month continuous irradiation test performed with the use of artificial solar light.

However, the sealing material (seal member) disclosed in JP-A-2000-30767 suffers from swelling or degradation of the resin with the electrolyte solution during prolonged sealing use, and has unsatisfactory properties. The sealing material disclosed in JP-A-2004-95248 requires heating to 80°C to 150°C for curing. The heating evaporates the electrolyte solution, leading to separation of the seal member.

This results in leakage of the electrolyte solution.

Further, the dye-sensitized solar cell having the construction described in JP-A-2009-266778 still has unsatisfactory durability in temperature and humidity load conditions of environment and endurance tests specified in JIS C8938 which presupposes outdoor installation (a temperature cycle test A-1 to be performed in a temperature range between -40°C and 85°C at 85 %RH in 10 cycles, a heat resistance test B-1 to be performed at 85°C for 1000 hours, and a moisture resistance test B-2 to be performed at 85°C at 85 %RH for 1000 hours).

A dye-sensitized solar cell is provided which includes a counter electrode substrate of a metal (particularly metal titanium), and a seal member free from the swelling and the degradation during prolonged sealing use and highly excellent in sealability.

### SUMMARY OF THE INVENTION

The dye-sensitized solar cell includes: a pair of electrode substrates, one of which is a metal electrode substrate and the other of which is a glass substrate having a transparent electrically conductive electrode film, the electrode substrates being spaced a predetermined distance from each other with an electrode surface of the metal electrode substrate and the transparent electrically conductive electrode film facing inward; a seal member disposed along peripheries of inner surfaces of the electrode substrates to seal a space defined between the electrode substrates; and an electrolyte solution filled in the sealed space; wherein the metal electrode substrate is a metal oxide coated metal electrode substrate which has a surface coated with a metal oxide film; wherein the seal member is composed of a material cured by photopolymerizing the following photopolymerizable composition (A); wherein the metal oxide coated metal electrode substrate and the glass substrate each have a portion coated with a silane coupling agent of a (meth)acryloxyalkylsilane in contact with the seal member:
(A) a photopolymerizable composition comprising a hydrogenated elastomer derivative having at least one (meth)acryloyl group at at least one of its opposite molecular terminals.

Photopolymerizable resin compositions containing a photopolymerizable resin as an effective component are useful as a sealing material. The specific photopolymerizable composition described above is particularly effective as the sealing material among the photopolymerizable resin compositions. Further, , where the specific surface coating treatment is performed on the portions of the electrode substrates to be brought into contact with the seal member and the metal electrode substrate coated with the metal oxide film is used as one of the paired electrode substrates, the metal oxide film effectively forms chemical bonds with the silane coupling agent of the (meth) acryloxyalkylsilane by a reaction with an alkoxy group of the silane coupling agent, and this is essential for effective sealing.

In the inventive dye-sensitized solar cell, as described above, the seal member is composed of the material cured by photopolymerizing the photopolymerizable composition (A), of comprising the hydrogenated elastomer derivative having at least one (meth)acryloyl group at at least one of its opposite molecular terminals, and the portions of the metal oxide coated metal electrode substrate and the glass substrate in contact with the seal member are coated with the silane coupling agent of the (meth)acryloxyalkylsilane. That is, the present invention eliminates the need for the heat-curing because the seal member is composed of the material cured by the photopolymerization, so that the separation of the seal member is prevented which may otherwise occur due to the evaporation of the electrolyte solution caused by the heating. The material for the seal member is a material cured by photopolymerizing the specific photopolymerizable composition (A) and, therefore, is free from the swelling and the degradation with the electrolyte solution during prolonged sealing use. In addition, the synergetic effect of the aforementioned specific silane coupling agent on the metal oxide coated metal electrode substrate and the glass electrode substrate ensures higher adhesiveness and higher durability.

The silane coupling agent is of the (meth)acryloxyalkylsilane. With the use of the silane coupling agent, photopolymerizable (meth)acryloyl groups are present in surface coating layers on the metal oxide coated metal electrode substrate and the glass substrate, and undergo the photopolymerization reaction together with the (meth) acryloyl groups in the photopolymerizable composition (A) to provide strong adhesiveness.

Where the metal oxide coated metal electrode substrate is a metal electrode substrate having an electrically conductive film formed of at least one of platinum and carbon, the dye-sensitize solar cell is less expensive, and lighter in weight.

Where the metal oxide coated metal electrode substrate is a substrate having an electrically conductive carbon film, the dye-sensitize solar cell is less expensive, lighter in weight, and excellent in photo-electric conversion efficiency.

Where 3-(meth)acryloxypropyltrimethoxysilane is used as the silane coupling agent, the seal member has further excellent adhesiveness.

Where the hydrogenated elastomer derivative contains one of a hydrogenated polybutadiene and a hydrogenated polyisoprene in its main chain, the nonpolar structure of the main chain improves the durability against the electrolyte solution.

Where the hydrogenated elastomer derivative is one of a hydrogenated polybutadiene derivative and a hydrogenated polyisoprene derivative obtained through a reaction between a hydroxy(meth)acrylate compound and a corresponding one of a hydrogenated polybutadiene polyol and a hydrogenated polyisoprene polyol by using a polyisocyanate as a linking group, the seal member has further excellent adhesiveness and excellent durability.

Where the hydrogenated elastomer derivative is one of a hydrogenated polybutadiene derivative and a hydrogenated polyisoprene derivative obtained through a reaction between a (meth)acryloyl-containing isocyanate compound and a corresponding one of a hydrogenated polybutadiene polyol and a hydrogenated polyisoprene polyol, the seal member has further excellent adhesiveness and excellent durability as in the aforementioned case.

Where the photopolymerizable composition (A) contains a poly(meth)acrylate compound in addition to the hydrogenated elastomer derivative, the crosslinking density of the material for the seal member is increased. Therefore, the seal member is further excellent in durability and, when a photopolymerization initiator is used, the curability with ultraviolet (UV) radiation is improved.

### BRIEF DESCRIPTION OF THE DRAWLING

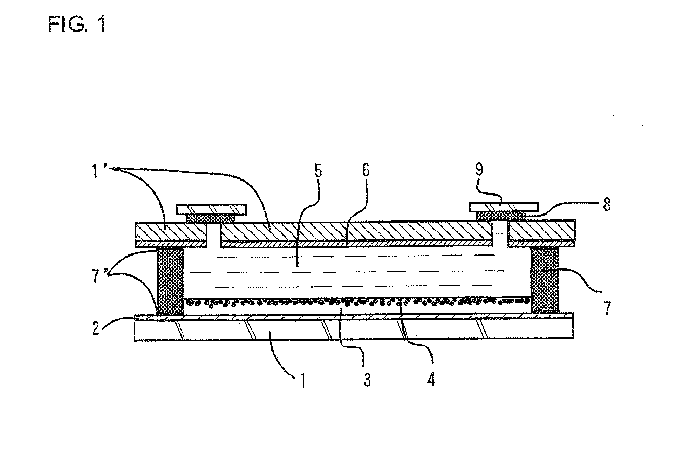

FIG. 1 is a sectional view illustrating an exemplary dye-sensitized solar cell.

### DETAILED DESCRIPTION OF THE INVENTION

An embodiment of the present invention will hereinafter be described.

A dye-sensitized solar cell includes: a pair of electrode substrates, one of which is a metal electrode substrate and the other of which is a glass substrate having a transparent electrically conductive electrode film; a seal member; and an electrolyte solution filled in a closed space defined by the pair of electrode substrates and the seal member. The metal electrode substrate is a metal oxide coated metal electrode substrate having a surface coated with a metal oxide film. The seal member is composed of a material cured by photopolymerizing a photopolymerizable composition (A) comprising a hydrogenated elastomer derivative having at least one (meth)acryloyl group at at least one of its opposite molecular terminals. That the metal oxide coated metal electrode substrate and the glass substrate each have a portion coated with a silane coupling agent of a (meth)acryloxyalkylsilane in contact with the seal member. The (meth) acryloyl group means an acryloyl group and a corresponding methacryloyl group shown below:

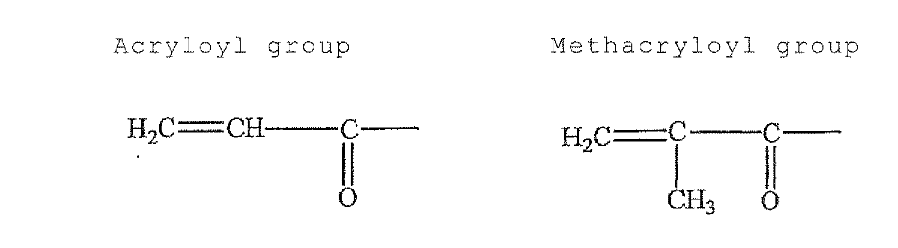

### Dye-Sensitized_Solar cell

The dye-sensitized solar cell is typically configured as shown in FIG. 1. More specifically, the dye-sensitized solar cell includes a metal oxide coated metal electrode substrate 1' and a glass substrate 1 having a transparent electrically conductive electrode film 2 (hereinafter sometimes referred to simply as "electrode substrate 1"). These electrode substrates 1, 1' are spaced a predetermined distance from each other with their electrically conductive electrode surfaces facing inward. A space defined between the electrode substrates 1 and 1' is sealed with a seal member 7 (main seal) formed from a specific photopolymerizable composition (A) and disposed along peripheral edges of the inner surfaces of the electrode substrates 1, 1'. An electrolyte solution 5 is filled in the sealed space. The electrode substrates 1, 1' each have a portion formed with a coating film 7' of a specific silane coupling agent in contact with the seal member 7.

As shown in FIG. 1, the dye-sensitized solar cell typically includes a porous semiconductor film 3 such as a titanium oxide film provided on the glass substrate 1. A sensitizing dye 4 is adsorbed on the porous semiconductor film 3. A catalyst film (electrically conductive film) 6 such as a very thin platinum or carbon film is provided on the electrically conductive electrode surface of the metal oxide coated metal electrode substrate 1'. In FIG. 1, the metal oxide coated metal electrode substrate 1' on the upper side serves as a positive electrode, and the glass substrate 1 on the lower side serves as a negative electrode.

In the dye-sensitized solar cell, as shown in FIG. 1, the metal oxide coated metal electrode substrate 1' typically has openings for injection of the electrolyte solution. The openings are each sealed with a seal member 8 (end seal). The seal member 8 is generally sealed with a seal cap 9 such as a thin glass piece. The dye-sensitized solar cell will hereinafter be described based on FIG. 1. However, the invention is not limited to the dye-sensitized solar cell shown in FIG. 1. The components of the dye-sensitized solar cell will be individually described below.

### Glass Substrate 1

The glass substrate 1 is a negative electrode substrate. The glass substrate 1 is typically required to have a visible light transmittance of higher than 80%. The visible light transmittance is measured by a commercially available common visible light transmittance meter.

Exemplary materials for the glass substrate 1 include white glass, soda glass and borosilicate glass.

In general, the glass substrate 1 is not electrically conductive. In order to use the glass substrate 1 as the electrode substrate, the glass substrate 1 is used as a support base, and the transparent electrically conductive electrode film 2 is provided on one surface of the support base. Exemplary materials for the transparent electrically conductive film 2 include indium-tin complex oxide (ITO), fluorine-doped tin oxide (FTO), antimony-doped tin oxide (ATO) and tin oxide, which may be used either alone or in combination.

### Metal Oxide Coated Metal Electrode Substrate 1'

The metal oxide coated metal electrode substrate 1' serving as the positive electrode is an opaque or translucent electrode substrate. The term "translucent" means that the visible light transmittance is higher than 0% and not higher than 80%. The term "opaque" means that the visible light transmittance is 0%. As described above, the visible light transmittance is measured by a commercially available common visible light transmittance meter. The metal oxide coated metal electrode substrate 1' typically has a visible light transmittance of not higher than 80% as described above, preferably not higher than 70%, more preferably not higher than 60%.

The metal oxide coated metal electrode substrate 1' is a metal substrate formed with a metal oxide film. Examples of the metal substrate include metal substrates such as titanium, tungsten, gold, silver and copper. Particularly, a titanium substrate formed with a metal oxide film is preferred for corrosion resistance.

To ensure evenness in in-plane thickness, the metal oxide film preferably has a thickness of not less than 50 nm, more preferably not less than 100 nm. If the thickness is too small, a reaction with a silane coupling agent of a (meth) acryloxyalkylsilane is liable to insufficiently proceed. If the thickness is not less than 100 nm, the reaction with the (meth)acryloxyalkylsilane silane coupling agent sufficiently proceeds to improve the adhesion to the seal member 7.

In general, any of various known methods such as an atmospheric pressure oxidation method involving firing in an electric oven or the like, a chemical oxidation method using nitric acid, and an anodic oxidation method may be employed for the formation of the metal oxide film. Particularly, where the substrate is made of metal titanium, a metal oxide film (passivation film) formed on the substrate in a moisture-containing atmosphere is liable to be embrittled in the presence of hydrogen. Therefore, it is preferred to densely form the passivation film in the stream of an inert gas such as nitrogen in the atmospheric pressure oxidation method.

The metal oxide film is preferably a titanium oxide film. More specifically, the metal oxide film preferably contains a titanium element having a valence of not less than 4 in a proportion of not less than 95 wt%, more preferably not less than 98 wt%. It is particularly preferred that the metal oxide film is substantially a tetravalent titanium oxide film.

The metal oxide film preferably has a thickness of not less than 50 nm, particularly preferably not less than 100 nm. An upper limit of the thickness is typically 10000 nm.

The thickness of the metal oxide film (passivation film) is determined, for example, by observing an increase in a Ti2P3/2 peak attributable to tetravalent titanium among a Ti2P3/2 peak attributable to metal titanium (at about 454.5 eV), a peak attributable to divalent titanium (at about 455.5 eV), a peak attributable to trivalent titanium (at about 457.0 eV) and a peak attributable to tetravalent titanium (at about 458.5 eV) in a spectrum obtained in ESCA depth profile measurement during the firing. The depthwise thickness of the metal oxide film is determined by measuring an area percentage in the spectrum.

### Porous Semiconductor Film 3

The porous semiconductor film 3 provided on the glass substrate 1 is not particularly limited, but is preferably, for example, a porous n-type metal oxide semiconductor film such as a filmmade of titanium oxide. Semiconductor particles to be employed for formation of the porous semiconductor film 3 may be in a granular form, a needle-like form, a tubular form, a cylindrical form or other linear form. The semiconductor particles of any of these linear forms may be present in combination.

### Sensitizing Dye 4

The sensitizing dye 4 adsorbed on the porous semiconductor film 3 is, for example, a sensitizing dye that is capable of absorbing solar light having a wavelength of 300 to 2000 nm and adsorbable on the porous semiconductor film 3. Exemplary materials for the sensitizing dye 4 include inorganic semiconductors such as silicon, gallium arsenide, indium phosphide, cadmium selenide, cadmium sulfide and CuInSe, inorganic pigments such as of chromium oxide, iron oxide and nickel oxide, and organic pigments such as of ruthenium complex, porphyrin, phthalocyanine, merocyanine, coumarin and indoline.

### Electrolyte Solution 5

The electrolyte solution 5 filled in the space between the electrode substrates 1 and 1' is an electrolyte-containing liquid, and includes an electrolyte and a liquid medium. Examples of the electrolyte include iodine-containing quaternary ammonium salts and lithium salts. Examples of the liquid medium include ethylene carbonate, acetonitrile and methoxypropionitrile. The electrolyte solution is prepared by mixing tetrapropylammonium iodide, lithium iodide, iodine or the like in any of these liquid media.

### Catalyst Film 6

A very thin film such as a film made of platinum or carbon is provided as the catalyst film (electrically conductive film) 6 on the inner surface (electrically conductive electrode surface) of the metal oxide coated metal electrode substrates 1' (on the side of the electrolyte solution). This improves the migration of positive holes in the metal oxide coated metal electrode substrate 1'. It is particularly preferred to employ a platinum vapor deposition film. However, the provision of the catalyst film 6 is not essential. Coating Films 7'

As described above, the coating films 7' are formed on the portions of the electrode substrates 1, 1' to be brought into contact with the seal member 7 by applying the silane coupling agent of the (meth)acryloxyalkylsilane. Examples of the (meth)acryloxyalkylsilane silane coupling agent include acryloxyalkylsilanes and methacryloxyalkylsilanes. Preferred examples of the (meth)acryloxyalkylsilane include 3-acryloxypropyltrimethoxysilane and 3-methacryloxypropyltrimethoxysilane, of which 3-acryloxypropyltrimethoxysilane having higher photopolymerization reactivity is more preferred. These (meth) acryloxyalkylsilane silane coupling agents may be used either alone or in combination.

The formation of the coating films is achieved by dissolving 0.01 to 5.0 wt% of the (meth)acryloxyalkylsilane silane coupling agent in an organic solvent such as methanol or ethanol to prepare a silane coupling agent solution, applying the solution on the portions of the electrode substrates 1, 1' to be brought into contact with the seal member 7, and heating the resulting electrode substrates 1, 1' to 60°C to 150°C. At a heat-drying temperature of 60°C to 150°C, the organic solvent such as methanol or ethanol is evaporated away in about 5 to about 30 minutes, whereby the coating films of the (meth)acryloxyalkylsilane silane coupling agent are formed by the surface coating treatment.

### Seal Member 7

The seal member 7 provided between the electrode substrates 1 and 1' is composed of the material cured by photopolymerizing the aforementioned photopolymerizable composition (A). The photopolymerizable composition (A) comprises the hydrogenated elastomer derivative, preferably, as its major component. The hydrogenated elastomer derivative is not particularly limited as long as it has at least one (meth)acryloyl group at at least one of its opposite molecular terminals. The major chain of the hydrogenated elastomer derivative is preferably a hydrogenated polybutadiene or a hydrogenated polyisoprene.

Examples of the hydrogenated polybutadiene as the main chain of the hydrogenated elastomer derivative include hydrogenated 1, 4-polybutadienes, hydrogenated 1,2-polybutadienes, and copolymers and the like of hydrogenated 1,4-polybutadienes and hydrogenated 1,2-polybutadienes. Examples of the hydrogenated polyisoprene include hydrogenated 1,4-polyisoprenes, hydrogenated 1,2-polyisoprenes, and copolymers and the like of hydrogenated 1,4-polyisoprenes and hydrogenated 1,2-polyisoprenes.

More preferably, the hydrogenated elastomer derivative is a hydrogenated polybutadiene derivative (a1) or a hydrogenated polyisoprene derivative (a2) obtained through a reaction between a hydrogenated polybutadiene polyol and a hydroxy(meth)acrylate compound or between a hydrogenated polyisoprene polyol and the hydroxy(meth)acrylate compound by using a polyisocyanate as a linking group. Further, the hydrogenated elastomer derivative may be a hydrogenated polybutadiene derivative (a3) or a hydrogenated polyisoprene derivative (a4) obtained through a reaction between a hydrogenated polybutadiene polyol and a (meth) acrployl-containing isocyanate compound or between a hydrogenated polyisoprene polyol and the (meth)acryloyl-containing isocyanate compound.

Components to be employed for synthesis of the hydrogenated polybutadiene derivative (a1) or the hydrogenated polyisoprene derivative (a2) through the reaction between the hydrogenated polybutadiene polyol and the hydroxy(meth)acrylate compound or between the hydrogenated polyisoprene polyol and the hydroxy(meth)acrylate compound by using the polyisocyanate as the linking group will be described.

The hydrogenated polybutadiene polyol and the hydrogenated polyisoprene polyol are preferably telechelic polymers each having reactive functional groups such as hydroxyl groups at opposite molecular terminals thereof. Examples of the hydrogenated polybutadiene polyol and the hydrogenated polyisoprene polyol include hydrogenated polybutadienes and hydrogenated polyisoprenes each having hydroxyl groups at opposite molecular terminals thereof.

The hydrogenated polybutadiene polyol is preferably a liquid hydrogenated polybutadiene polyol having a number average molecular weight of 500 to 5000, and the hydrogenated polyisoprene polyol is preferably a liquid hydrogenated polyisoprene polyol having a number average molecular weight of 500 to 130000.

Examples of the polyisocyanate serving as the linking group include hexamethylene diisocyanate, norbornene diisocyanate, isophorone diisocyanate, xylylene diisocyanate, hydrogenated xylylene diisocyanate, dicyclohexylmethane diisocyanate, tolylene diisocyanate, diphenylmethane diisocyanate and naphthalene diisocyanate, which may be used either alone or in combination. Particularly, saturated diisocyanates such as hexamethylene diisocyanate, norbornene diisocyanate, isophorone diisocyanate, hydrogenated xylylene diisocyanate and dicyclohexylmethane diisocyanate are preferably used.

Examples of the hydroxy(meth)acrylate compound include monofunctional hydroxy(meth)acrylate compounds such as 2-hydroxyethyl (meth)acrylate, 2-hydroxypropyl (meth)acrylate, 2-hydroxybutyl (meth)acrylate, 2-hydroxyethyl (meth)acryloyl phosphate, 4-hydroxybutyl (meth)acrylate and 2-(meth)acryloyloxyethyl-2-hydroxypropyl phthalate, difunctional hydroxy(meth)acrylate compounds such as glycerin di(meth)acrylate and trimethylolpropane di(meth)acrylate, and multifunctional hydroxy(meth)acrylate compounds such as 2-hydroxy-1,3-dimethacryloxypropane (glycerin dimethacrylate) and pentaerythritol tri(meth)acrylate, among which the multifunctional hydroxy (meth) acrylate compounds having two or more functional groups are preferred for improvement of the crosslinking density. In the present invention, the (meth)acrylate means an acrylate and a corresponding methacrylate.

For the synthesis, the proportions of the hydrogenated polybutadiene polyol or the hydrogenated polyisoprene polyol, the polyisocyanate and the hydroxy(meth)acrylate compound are as follows:

The polyisocyanate is preferably blended in a proportion of 2 to 10 equivalents, more preferably 4 to 8 equivalents, per hydroxyl equivalent (an average molecular weight per hydroxyl group) of the hydrogenated polybutadiene polyol or the hydrogenated polyisoprene polyol. If the proportion is less than 2 equivalents, a higher molecular weight linear polymer is liable to be produced. If the proportion is greater than 10 equivalents, a greater number of unreacted isocyanate groups tend to remain.

The hydroxy(meth)acrylate compound is preferably blended in a proportion of 1 to 2 equivalents, more preferably 1.1 to 1.3 equivalents, per isocyanate equivalent (a molecular weight per isocyanate group) of the polyisocyanate. If the proportion is less than 1 equivalent, isocyanate groups tend to remain. If the proportion is greater than 2 equivalents, a greater amount of the hydroxy(meth)acrylate compound tends to remain.

The hydrogenated polybutadiene derivative (a1) or the hydrogenated polyisoprene derivative (a2) is synthesized, for example, in the following manner. The hydrogenated polybutadiene polyol or the hydrogenated polyisoprene polyol is caused to react with the polyisocyanate in the presence of a catalyst of a metal such as titanium or tin or an organic metal salt such as dibutyltin laurate. After the hydroxyl groups of the hydrogenated polybutadiene polyol or the hydrogenated polyisoprene polyol sufficiently react with the isocyanate groups, the hydroxy(meth)acrylate compound is added for a reaction with the residual isocyanate groups. Thus, the hydrogenated elastomer derivative is provided. Where the resulting hydrogenated elastomer derivative is highly viscous or semi-solid, the hydrogenated elastomer derivative is heated to 30°C to 80°C, or a solvent such as toluene or xylene is added to the reaction system. Thus, the reaction smoothly proceeds, thereby facilitating the synthesis.

The degree of the synthesis reaction can be determined by measuring an infrared absorbance at a characteristic absorption band attributable to the isocyanate group (at about 2260 cm⁻¹) in an infrared absorption spectrum, because the absorbance at the characteristic absorption band attributable to the isocyanate group is reduced as the reaction proceeds. The completion of the synthesis reaction is determined based on the fact that the absorbance at the characteristic absorption band attributable to the isocyanate group is reduced to zero.

After the completion of the reaction, the reaction product is rinsed with a solvent such as acetonitrile for removal of a soluble component thereof, and then the solvent is removed in a known manner by means of an evaporator or the like. Thus, the hydrogenated elastomer derivative having at least one (meth) acryloyl group at at least one of its opposite molecular terminals is provided.

On the other hand, components to be employed for synthesis of the hydrogenated polybutadiene derivative (a3) or the hydrogenated polyisoprene derivative (a4) through the reaction between the hydrogenated polybutadiene polyol and the (meth)acryloyl-containing isocyanate compound or between the hydrogenated polyisoprene polyol and the (meth)acryloyl-containing isocyanate compound will be described.

The hydrogenated polybutadiene polyol and the hydrogenated polyisoprene polyol are preferably telechelic polymers each having reactive functional groups such as hydroxyl groups at opposite molecular terminals thereof. Examples of the hydrogenated polybutadiene polyol and the hydrogenated polyisoprene polyol include hydrogenated polybutadienes and hydrogenated polyisoprenes each having hydroxyl groups at opposite molecular terminals thereof.

The hydrogenated polybutadiene polyol is preferably a liquid hydrogenated polybutadiene polyol having a number average molecular weight of 500 to 5000, and the hydrogenated polyisoprene polyol is preferably a liquid hydrogenated polyisoprene polyol having a number average molecular weight of 500 to 130000.

Examples of the (meth)acryloyl-containing isocyanate compound include 2-(meth)acryloyloxyethyl isocyanate and 1,1-bis(acryloyloxymethyl) ethyl isocyanate.

For the synthesis, the proportions of the hydrogenated polybutadiene polyol or the hydrogenated polyisoprene polyol and the (meth)acryloyl-containing isocyanate compound are as follows:

The (meth)acryloyl-containing isocyanate compound is preferably blended in a proportion of 1 to 3 equivalents, more preferably 1.2 to 2 equivalents, per hydroxyl equivalent (an average molecular weight per hydroxyl group) of the hydrogenated polybutadiene polyol or the hydrogenated polyisoprene polyol. If the proportion is less than 1 equivalent, unreacted hydroxyl groups tend to remain. If the proportion is greater than 3 equivalents, unreacted isocyanate groups tend to remain.

The hydrogenated polybutadiene derivative (a3) or the hydrogenated polyisoprene derivative (a4) is synthesized, for example, in the following manner. The hydrogenated polybutadiene polyol or the hydrogenated polyisoprene polyol is caused to react with the (meth)acryloyl-containing isocyanate compound in the presence of a catalyst of a metal such as titanium or tin or an organic metal salt such as dibutyltin laurate. The reaction between the hydroxyl groups of the hydrogenated polybutadiene polyol or the hydrogenated polyisoprene polyol and the isocyanate groups of the (meth)acryloyl-containing isocyanate compound provides the hydrogenated elastomer derivative. Where the resulting hydrogenated elastomer derivative is highly viscous or semi-solid, the hydrogenated elastomer derivative is heated to 30°C to 80°C, or a solvent such as toluene or xylene is added to the reaction system. Thus, the reaction smoothly proceeds, thereby facilitating the synthesis.

The degree of the synthesis reaction can be determined by measuring an infrared absorbance at a characteristic absorption band attributable to the isocyanate group (at about 2260 cm⁻¹) in an infrared absorption spectrum, because the absorbance at the characteristic absorption band attributable to the isocyanate group is reduced as the reaction proceeds. The completion of the synthesis reaction is determined based on the fact that the absorbance at the characteristic absorption band attributable to the isocyanate group is reduced to zero.

After the completion of the reaction, the reaction product is rinsed with a solvent such as acetonitrile for removal of a soluble component thereof, and then the solvent is removed in a known manner by means of an evaporator or the like. Thus, the hydrogenated elastomer derivative having at least one (meth) acryloyl group at at least one of its opposite molecular terminals is provided.

The proportion of the hydrogenated elastomer derivative is preferably 1 to 99 wt%, more preferably 10 to 90 wt%, based on the overall amount of the photopolymerizable composition (A).

The photopolymerizable composition (A) to be used for the seal member 7 contains any of the aforementioned various hydrogenated elastomer derivatives, and may contain a phyllosilicate and/or an insulative spherical inorganic filler as optional components. These optional components may be used either alone or in combination.

The phyllosilicate is a silicate mineral having interlaminar ion exchangeability, and may be a naturally occurring phyllosilicate or a synthesized phyllosilicate. The phyllosilicate is not particularly limited, but examples thereof include smectite clay minerals such as montmorillonite, saponite, hectorite, beidellite, stevensite and nontrolite, and swellable mica, vermiculite and halloysite, which may be used either alone or in combination. Particularly, at least one of swellable mica and lipophilic smectite each subjected to an organic treatment and having affinity for an organic solvent with their interlaminar Na ions exchanged with cations is preferably used.

The form of the phyllosilicate is not particularly limited, but the phyllosilicate is preferably in the form of crystalline particles having an average length of 0.005 to 10 µm and a thickness of 0.001 to 5 µm with an aspect ratio of 10 to 500.

The phyllosilicate is a laminar clay mineral having metal cations such as Na ions intercalated between its layers. A phyllosilicate organically treated with dimethyl distearyl ammonium chloride, chloroaminolauric acid, a quaternary ammonium salt or a quaternary phosphonium salt for ion exchange of the Na ions is preferably used. The organically treated phyllosilicate with its Na ions ion-exchanged has higher affinity for the resin and, therefore, can be easily dispersed in the resin by means of a high-speed shearing dispersing machine such as a three-roll mill or a ball mill.

Examples of the insulative spherical inorganic filler include silica powder, alumina powder, titanium oxide powder, calcium carbonate powder and calcium silicate powder, which may be used either alone or in combination. It is possible to design the insulative spherical inorganic filler in any desired manner to impart surfaces of the filler with a hydrophobic property or a hydrophilic property for dispersibility of the filler in the hydrogenated elastomer derivative. For easier improvement of the affinity for the resin component, the silica powder is preferably used, and fused spherical silica powder is particularly preferred.

The insulative spherical inorganic filler preferably has an average particle diameter of 0.01 to 1 µm and a maximum particle diameter of not greater than 10 µm, more preferably an average particle diameter of 0.05 to 1 µm and a maximum particle diameter of not greater than 1 µm. If the average particle diameter is too small, it is impossible to increase the filling percentage with an excessively great specific surface area, so that the effect of reducing the moisture permeability of the cured material is insufficient. If the average particle diameter is too great, the UV transmissive property of the seal member is impaired, so that the photo-curability is unsatisfactory. If the maximum particle diameter is greater than 10 µm, the UV transmissive property is impaired, so that the photo-curability is unsatisfactory.

The average particle diameter and the maximum particle diameter are measured, for example, by means of a laser diffraction-scattering particle size distribution analyzer. The values of the average particle diameter and the maximum particle diameter are determined with the use of samples arbitrarily extracted from a population by means of the aforementioned analyzer.

The organically treated phyllosilicates out of the aforementioned phyllosilicates, and the insulative spherical inorganic fillers are preferably chemically surface-modified. This improves the affinity for the resin component such as the hydrogenated elastomer derivative, thereby reducing the viscosity of the uncured solution and improving the dispersibility of the phyllosilicate and the insulative spherical inorganic filler.

A compound to be used for the chemical modification is not particularly limited, as long as it is reactive with functional groups such as hydroxyl groups and carboxyl groups present in surfaces of the organically treated phyllosilicate and the insulative spherical inorganic filler. Preferred examples of such a compound include reactive silane compounds such as silane coupling agents and silylation agents, titanate compounds and isocyanate compounds, which may be used either alone or in combination.

The compound for the chemical modification is used in the same manner as in a conventionally known surface treatment of an inorganic filler, e.g., a surface treatment to be performed in an organic solvent.

Examples of the silane coupling agent include 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-triethoxysilyl-N-(1,3-dimethylbutylidene)propylamine, N-phenyl-3-aminopropyltriethoxysilane, a hydrochloric acid salt of N-(vinylbenzyl)-2-aminoethyl-3-aminopropyltrimethoxysilane, 3-ureidopropyltrimethoxysilane, 3-chloropropyltrimethoxysilane, 3-mercaptopropylmethyldimethoxysilane, 3-mercaptopropyltrimethoxysilane, bis(triethoxysilylpropyl) tetrasulfide and 3-isocyanatopropyltriethoxysilane, which may be used either alone or in combination.

Examples of the silylation agent include methyltrichlorosilane, methyldichlorosilane, dimethyldichlorosilane, trimethylchlorosilane, phenyltrichlorosilane, diphenyldichlorosilane, trifluoropropyltrichlorosilane and hexamethyldisilazane, which may be used either alone or in combination.

Examples of the titanate compound include tetraalkyl titanate compounds such as tetraisopropyl titanate and tetra-n-butyl titanate, and their lower molecular weight condensation products, which may be used either alone or in combination.

Examples of the isocyanate compound include (meth)acryloxyisocyanate compounds such as 2-isocyanatoethyl methacrylate, 2-isocyanatoethyl acrylate and 1,1-bis(acryloxymethyl)ethyl isocyanate, which may be used either alone or in combination.

The phyllosilicate is preferably present in the photopolymerizable composition (A) in a proportion of 0.1 to 20 wt%, more preferably 1 to 10 wt%, based on the overall amount of the sealing material. If the proportion is too small, the moisture permeability of the sealing material is insufficiently reduced. If the proportion is too great, the viscosity of the uncured liquid sealing material is extremely high, thereby causing a problem in a coating process.

The insulative spherical inorganic filler is preferably present in the photopolymerizable composition (A) in a proportion of 30 to 70 wt%, more preferably 40 to 60 wt%, based on the overall amount of the sealing material. If the proportion is too small, the moisture permeability of the sealing material is insufficiently reduced. If the proportion is too great, the viscosity of the uncured liquid sealing material is extremely high, thereby causing a problem in the coating process.

As required, the photopolymerizable composition (A) may further contain a poly(meth)acrylate compound (b) and a photopolymerization initiator (c) as optional components.

The poly(meth)acrylate compound (b) serves as a diluent when the hydrogenated elastomer derivative is blended in the photopolymerizable composition (A), and serves as a crosslinking agent when the photopolymerizable composition (A) is cured. Examples of the poly(meth)acrylate compound include multifunctional (meth)acrylates.

Examples of the multifunctional (meth)acrylates include difunctional (meth)acrylates such as 1,4-butanediol di(meth)acrylate, 1,6-hexanediol di(meth)acrylate, 1,9-nonanediol di(meth)acrylate, 1,10-decanediol di(meth)acrylate, 1,12-dodecanediol di(meth)acrylate, 1,12-octadecanediol di(meth)acrylate, 2-n-butyl-2-ethyl-1,3-propanediol di(meth)acrylate, tripropyleneglycol di(meth)acrylate, norbornene di(meth)acrylate and dimethyloldicyclopentane di(meth)acrylate (tricyclodecanedimethanol di(meth)acrylate), trifunctional (meth)acrylates such as trimethylolpropane tri(meth)acrylate and pentaerythritol tri(meth)acrylate, and other poly (meth) acrylate compounds, which may be used either alone or in combination. For compatibility with the hydrogenated elastomer derivative, dimethyloldicyclopentane di(meth)acrylate (tricyclodecanedimethanol diacrylate) is preferably used.

A monofunctional (meth)acrylate may be used in combination with any of the aforementioned multifunctional (meth)acrylates as the poly(meth)acrylate compound (b), as long as the adhesiveness of the seal member of the dye-sensitized solar cell is not impaired.

Examples of the monofunctional (meth)acrylate include isobutyl (meth)acrylate, t-butyl (meth)acrylate, isooctyl (meth)acrylate, lauryl (meth)acrylate, styryl (meth)acrylate, isobonyl (meth)acrylate and cyclohexyl (meth)acrylate, which may be used either alone or in combination.

The proportion of the poly (meth) acrylate compound (b) is preferably 1 to 99 wt%, more preferably 10 to 90 wt%, based on the overall amount of the photopolymerizable composition (A).

Usable as the photopolymerization initiator (c) is a known photo-radical generator. Examples of the photopolymerization initiator include 2,2-dimethoxy-1,2-diphenylethan-1-one, 1-hydroxycyclohexyl phenyl ketone, 2-hydroxy-2-methyl-1-phenylpropan-1-one, 2-methyl-1-(4-methylthiophenyl)-2-morpholinopropan-1-one, bis(2,4,6-trimethylbenzoyl)-phenylphosphine oxide, which may be used either alone or in combination.

The proportion of the photopolymerization initiator (c) is preferably 0.1 to 30 wt%, more preferably 0.5 to 20 wt%, based on the overall amount of the photopolymerizable composition (A). If the proportion is less than 0.1 wt%, the polymerization degree tends to be insufficient. If the proportion is greater than 30 wt%, the amount of a decomposition residue is increased, and the durability of the seal member tends to be impaired.

In addition to the aforementioned components, other additives such as an antioxidant, a defoaming agent, a surfactant, a colorant, an inorganic filler, an organic filler, various spacers and a solvent may be blended, as required, in the photopolymerizable composition (A) to be used for the seal member 7. These additives may be used either alone or in combination.

The photopolymerizable composition (A) thus prepared is irradiated with ultraviolet radiation by means of a UV lamp or the like and, as required, post-cured at a predetermined temperature to form the seal member 7.

### End Seal Members 8

In the dye-sensitized solar cell shown in FIG. 1, the metal oxide coated metal electrode substrate 1' provided on the upper side has the openings for the injection of the electrolyte solution. However, the openings are not necessarily required to be provided in the electrode substrate 1', but may be provided in the seal member 7, the electrode substrate 1 or the like. The openings are respectively end-sealed with the end seal members 8. The end seal members 8 are typically formed by employing the same photopolymerizable composition (A) and the same curing method. Further, a conventionally known material is used for the seal caps 9 of the thin glass pieces for sealing the end seal members 8.

### Production Method of Dye-Sensitized Solar Cell

Next, a method of producing the dye-sensitized solar cell from the aforementioned materials will be described. The dye-sensitized solar cell shown in FIG. 1 is produced, for example, in the following manner.

First, a glass substrate 1 formed with a transparent electrically conductive electrode film 2 and a porous semiconductor film 3 on which a sensitizing dye 4 is adsorbed is prepared. Then, a portion of the glass substrate 1 to be brought into contact with a seal member 7 is surface-coated with a silane coupling agent of a (meth)acryloxyalkylsilane. As described above, this surface coating treatment is performed, for example, by dissolving 0.01 to 5.0 wt% of the (meth)acryloxyalkylsilane silane coupling agent in an organic solvent such as methanol or ethanol, applying the resulting solution onto the portion of the glass substrate 1 to be brought into contact with the seal member 7, and heating the resulting glass substrate 1 to 60°C to 150°C. Thus, a coating film 7' is formed from the applied solution.

On the other hand, a catalyst film 6 such as a platinum vapor deposition film is formed on an electrically conductive electrode surface (on an electrolyte solution side) of a metal oxide coated metal electrode substrate 1' to be opposed to the glass substrate 1 by a sputtering method or the like. Then, a portion of the electrode substrate 1' to be brought into contact with the seal member 7 is surface-coated with the (meth)acryloxyalkylsilane silane coupling agent in the same manner as described for the glass substrate 1. Thus, a coating film 7' is formed.

The photopolymerizable composition (A) preliminarily prepared is applied onto the predetermined portion of at least one of the glass substrate 1 and the metal oxide coated metal electrode substrate 1', whereby the seal member 7 is formed in an unpolymerized state (uncured state). Then, the electrode substrates 1, 1' are bonded to each other with the seal member 7 with the electrically conductive electrode surfaces thereof facing inward, and the seal member 7 is irradiated with ultraviolet radiation emitted by means of an ultraviolet radiation emitting device such as a high pressure mercury lamp (preferably in a nitrogen atmosphere) to be thereby cured for main sealing. Conditions for the irradiation with the ultraviolet radiation are, for example, an irradiation intensity of 0.5 to 10000 mW/cm² and an irradiation period of 0.5 to 600 seconds.

In turn, the electrolyte solution 5 is injected into a space defined between the bonded electrode substrates 1 and 1' through one of openings formed in the metal oxide coated metal electrode substrate 1', and then seal caps 9 of thin glass pieces on which the same compositions as for the seal member 7 and the coating films 7' are applied are respectively placed over the openings. The photopolymerizable composition (A) is polymerized (cured) in the same manner as described above by irradiation with ultraviolet radiation to seal the openings (to form end seal members 8). Thus, the dye-sensitized solar cell shown in FIG. 1 is provided.

In the dye-sensitized solar cell shown in FIG. 1, the layer of the electrolyte solution, the seal member and the like may have a proper thickness (generally equal to a distance between the substrates) and a proper width according to the use purpose and application. In general, the seal member 7 preferably has a width of about 1 to about 5 mm and a thickness of 50 to 500 µm.

In the dye-sensitized solar cell, collector electrodes may be provided on the inner surface (on the electrolyte solution side) of at least one of the metal oxide coated metal electrode substrate 1' and the glass substrate 1 having the transparent electrically conductive electrode film.

The provision of the collector electrodes reduces the electrical resistance of the electrically conductive electrode surface to improve the photo-electric conversion efficiency. Preferred examples of a material for the collector electrodes include electrically conductive metals and metal oxides, carbon materials, and electrically conductive polymers. Examples of the metals include platinum, gold, silver, ruthenium, copper, aluminum, nickel, cobalt, chromium, iron, molybdenum, titanium and tantalum, and alloys of any of these metals. Examples of the carbon materials include graphite, carbon black, glassy carbon, carbon nano-tube and fullerene. It is advantageous to use a transparent or translucent metal oxide such as FTO, ITO, indium oxide or zinc oxide for the collector electrodes, because the amount of light incident on a sensitizing dye layer can be increased.

The collector electrodes are preferably each configured to have a width of 10 to 3000 µm and a thickness of 1 to 100 µm.

The collector electrodes are distributively arranged, for example, in a stripe form, a grid form, a radial form or a network form, preferably in a grid form, on the electrically conductive electrode surface of the electrode substrate.

The collector electrodes are respectively covered with covering protective members for protection thereof. For enhancement of adhesion between the collector electrodes and the covering protective members, a surface coating treatment is performed. In the surface coating treatment, coating films are respectively formed on portions of the collector electrodes to be brought into contact with the covering protective members on the electrode substrate by applying at least one of a glass agent and a silane coupling agent on the portions. The covering protective members are not required to be as highly adhesive as the sealing material (seal member 7). Therefore, the following glass agents and/or silane coupling agents may be used.

The covering protective members are employed for preventing breakage of the collector electrodes which may otherwise occur due to corrosion by the electrolyte solution. The covering protective members are composed of a material cured by photopolymerizing the photopolymerizable composition (A) which is resistant to the electrolyte solution and highly adhesive, and contains the hydrogenated elastomer derivative having at least one (meth)acryloyl group at at least one of its opposite molecular terminals. More specifically, the same material as for the seal member 7 described above may be used for the covering protective members.

Examples of the glass agent include SiO₂-Bi₂O₃-MOₓ glass agents and B₂O₃-Bi₂O₃-MOₓ glass agents (wherein M is at least one metal element and X is a positive number of 1 to 3), which contain oxides of Si, B and/or Bi as major components. These may be used either alone or in combination.

The silane coupling agent is not particularly limited, but examples thereof include 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-triethoxysilyl-N-(1,3-dimethylbutylidene)propylamine, N-phenyl-3-aminopropyltriethoxysilane, a hydrochloric acid salt of N-(vinylbenzyl)-2-aminoethyl-3-aminopropyltrimethoxysilane, 3-ureidopropyltrimethoxysilane, 3-chloropropyltrimethoxysilane, 3-mercaptopropylmethyldimethoxysilane, 3-mercaptopropyltrimethoxysilane, bis(triethoxysilylpropyl) tetrasulfide and 3-isocyanatopropyltriethoxysilane, which may be used either alone or in combination. The (meth)acryloxyalkylsilanes previously described are also advantageously usable.

Where the dye-sensitized solar cell includes the collector electrodes, the dye-sensitized solar cell is produced, for example, in the following manner. First, a glass substrate 1 is prepared. Then, the electrically conductive material, for example, is applied onto an electrically conductive electrode surface (on an electrolyte solution side) of the glass substrate 1 in a striped wiring pattern having a width of 10 to 3000 µm, a thickness of 1 to 100 µm and a pitch of 4 to 20 mm, and fired at 450°C to 750°C for 0.5 to 3 hours to form the collector electrodes.

In turn, 0.01 to 5.0 wt% of at least one of the glass agent and the silane coupling agent is dissolved in an organic solvent such as methanol or ethanol, and portions of the collector electrodes to be brought into contact with covering protective members are coated with the resulting solution or paste so as to form coating films each typically having a dry thickness of 0.01 to 0.3 mm. As required, portions of the glass substrate 1 to be brought into contact with the covering protective members may also be coated with the solution or the paste. After this coating treatment is performed at a room temperature, a heat treatment is preferably performed at 60°C to 700°C. Where the glass agent is used, the heat treatment is preferably performed at 500°C to 700°C. Where the silane coupling agent is used, the heat treatment is preferably performed at 60°C to 150°C. Thus, a surface coating treatment is completed to form the coating films.

Subsequently, the photopolymerizable composition (A) preliminarily prepared is typically applied to a thickness of 0.01 to 0.3 mm on the collector electrodes subjected to the surface coating treatment, whereby the collector electrodes are coated for protection thereof. Then, the polymerizable composition (A) is irradiated with ultraviolet radiation emitted by means of an ultraviolet radiation emitting device such as a high pressure mercury lamp. Conditions for the irradiation are preferably such that the irradiation intensity and the irradiation period are 0.5 to 10000 mW/cm² and 0.5 to 600 seconds, respectively, and the irradiation is preferably carried out in a nitrogen atmosphere. The photopolymerizable composition (A) is cured by the irradiation with the ultraviolet radiation to form the covering protective members.

Then, a titanium oxide paste, for example, is applied to a thickness of 5 to 50 µm in recesses defined by the collector electrodes and the covering protective members on the glass substrate 1, and fired at 450°C to 600°C for 0.5 to 3 hours to form a porous semiconductor film 3. Where a screen printing method or other highly accurate coating method is employed, the step of forming the porous semiconductor film 3 may precede any of the steps of providing the collector electrodes, performing the surface treatment and forming the covering protective members.

In turn, the glass substrate 1 formed with the porous semiconductor film 3 is dipped in an ethanol solution containing a sensitizing dye 4 at a controlled concentration. Thereafter, the electrode substrate is dipped in dehydrated ethanol for removal of an excess amount of the sensitizing dye 4, and then dried. Thus, the sensitizing dye 4 is adsorbed on the porous semiconductor film 3.

Steps subsequent to this step are performed in the same manner as in the dye-sensitized solar cell production method described above.

In this embodiment, the collector electrodes and the covering protective members are formed only on the glass substrate 1, but may be formed in the same manner on the metal oxide coated metal electrode substrate 1' to be opposed to the glass substrate 1. For the

photo-electric conversion efficiency, the collector electrodes and the covering protective members are preferably formed on each of the electrode substrates 1, 1'. Where the collector electrodes and the covering protective members are formed on the metal oxide coated metal electrode substrate 1', the formation of the collector electrodes and the covering protective members preferably precedes the formation of the catalyst film 6.

Inventive examples will be described in conjunction with comparative examples. It should be understood that the present invention is not limited to these inventive examples.

### EXAMPLES

Prior to implementation of the examples, ingredients for the following components were prepared or synthesized.

### (Meth)acryloxyalkylsilane silane coupling agent

As the (meth)acryloxyalkylsilane silane coupling agent, 3-acryloxypropyltrimethoxysilane and 3-methacryloxypropyltrimethoxysilane were prepared.

### Synthesis of elastomer derivatives

### a. Synthesis of hydrogenated elastomer derivative (a)

First, 15 g (0.01 mol) of a hydrogenated polybutadiene having hydroxyl groups at its opposite molecular terminals as represented by the following general formula (1) (having a number average molecular weight of about 1500, a hydroxyl value of 75 KOH mg/g, an iodine value of 10 I₂ mg/100g and a viscosity of 30 Pa·s/25°C), 10.2 g (0.05 mol) of norbornene diisocyanate and 20g of toluene were put in a glass reactor, and heated to 50°C in the stream of nitrogen gas. Then, 0.4 g of an ethyl acetate solution of 5 wt% dibutyltin laurate was added to the resulting mixture, and a reaction was allowed to proceed at 50°C for 6 hours. Thereafter, 0.001 g of hydroquinone and 20.7 g (0.09 mol) of 2-hydroxy-1,3-dimethacryloxypropane (glycerin dimethacrylate) were added to the resulting mixture, and a reaction was allowed to proceed at 60°C for 6 hours. In turn, the reaction product was poured in an excess amount of acetonitrile and stirred to be washed, and then a solid component was separated from a liquid component and dried at a reduced pressure. Thus, an intended hydrogenated elastomer derivative (a) was provided. The absorbance at a characteristic absorption band (about 2260 cm⁻¹) attributable to the isocyanate group in an infrared absorption spectrum of the reaction product (measured by a FT-IR analyzer available under Nicolet IR200 from Thermo Electron KK) was zero. Further, the weight average molecular weight (Mw) of the reaction product measured on the basis of a polystyrene calibration standard by means of a gel permeation chromatograph (GPC available under HLC-8120 from Toso Co., Ltd.) was 6150. 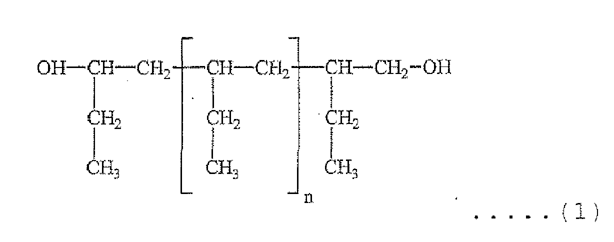 Wherein n is a positive integer.

### b. Synthesis of hydrogenated elastomer derivative (b)

A hydrogenated elastomer derivative (b) was synthesized in substantially the same manner as the hydrogenated elastomer derivative (a), except that 15 g (0.005 mol) of a hydrogenated polybutadiene having hydroxyl groups at its opposite molecular terminals as represented by the above general formula (1) (having a number average molecular weight of about 3000, a hydroxyl value of 30 KOH mg/g, an iodine value of 10 I₂ mg/100g and a viscosity of 80 Pa·s/25°C) was used instead of the hydrogenated polybutadiene (having a number average molecular weight of about 1500) used for the synthesis of the hydrogenated elastomer derivative (a). The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 7500.

### c. Synthesis of hydrogenated elastomer derivative (c)

A hydrogenated elastomer derivative (c) was synthesized in substantially the same manner as the hydrogenated elastomer derivative (a), except that 280 g (0.01 mol) of a hydrogenated polyisoprene having hydroxyl groups at its opposite molecular terminals as represented by the following general formula (2) (having a number average molecular weight of about 28000, a hydroxyl value of 4 KOH mg/g, an iodine value of 40 I₂ mg/100g and a viscosity of 1500 Pa·s/25°C) was used instead of the hydrogenated polybutadiene used for the synthesis of the hydrogenated elastomer derivative (a). The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 28800. 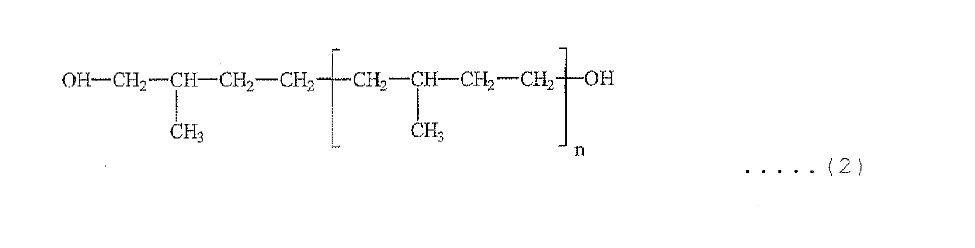 wherein n is a positive integer.

### d. Syntheses of hydrogenated elastomer derivative (d)

First, 15 g (0.01 mol) of the hydrogenated polybutadiene having a number average molecular weight of about 1500 for the synthesis of the hydrogenated elastomer derivative (a), 7 g (0.03 mol) of 1,1-bis(acryloyloxymethyl)ethyl isocyanate as the (meth)acryloyl-containing isocyanate compound and 0.3 g of an ethyl acetate solution of 5 wt% dibutyltin laurate were blended, and a reaction was allowed to proceed at 50°C for 6 hours in the stream of nitrogen gas. In turn, the reaction product was poured in an excess amount of acetonitrile and stirred to be washed, and then a solid component was separated from a liquid component and dried at a reduced pressure. Thus, an intended hydrogenated elastomer derivative (d) was provided. The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 5020.

### e. Synthesis of hydrogenated elastomer derivative (e)

A hydrogenated elastomer derivative (e) was synthesized in substantially the same manner as the hydrogenated elastomer derivative (d), except that 30 g (0.01 mol) of the hydrogenated polybutadiene having a number average molecular weight of about 3000 for the synthesis of the hydrogenated elastomer derivative (b) was used instead of the hydrogenated polybutadiene (having a number average molecular weight of about 1500) used for the synthesis of the hydrogenated elastomer derivative (d) and 15 g of toluene was used. The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 7290.

### f. Synthesis of hydrogenated elastomer derivative (f)

A hydrogenated elastomer derivative (f) was synthesized in substantially the same manner as the hydrogenated elastomer derivative (d), except that 280 g (0.01 mol) of a hydrogenated polyisoprene having hydroxyl groups at its opposite molecular terminals as represented by the above general formula (2) (having a number average molecular weight of about 28000, a hydroxyl value of 4 KOH mg/g, an iodine value of 40 I₂ mg/100g and a viscosity of 1500 Pa·s/25°C) was used instead of the hydrogenated polybutadiene (having a number average molecular weight of about 1500) used for the synthesis of the hydrogenated elastomer derivative (d) and 15 g of toluene was used. The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 7290.

### g. Synthesis of unsaturated elastomer derivative (g)

An unsaturated elastomer derivative (g) was synthesized in substantially the same manner as the hydrogenated elastomer derivative (a), except that 15 g (0.01 mol) of an unsaturated polybutadiene having hydroxyl groups at its opposite molecular terminals as represented by the following general formula (3) (having a number average molecular weight of about 1500, a hydroxyl value of 70 KOH mg/g and a viscosity of 90 Pa·s/25°C) was used instead of the hydrogenated polybutadiene (having a number average molecular weight of about 1500) used for the synthesis of the hydrogenated elastomer derivative (a). The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 5900. 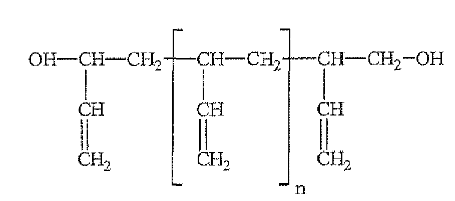 wherein n is a positive integer.

### h. Synthesis of unsaturated elastomer derivative (h)

An unsaturated elastomer derivative (h) was synthesized in substantially the same manner as the hydrogenated elastomer derivative (d), except that 15 g (0.01 mol) of the unsaturated polybutadiene having hydroxyl groups at its opposite molecular terminals as represented by the above general formula (3) for the synthesis of the unsaturated elastomer derivative (g) was used instead of the hydrogenated polybutadiene used for the synthesis of the hydrogenated elastomer derivative (d). The absorbance at a characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 4900.

### Poly(meth)acrylate compound

As the poly(meth)acrylate compound, dimethyloldicyclopentane diacrylate (tricyclodecanedimethanol diacrylate) and 1,6-hexanediol diacrylate were prepared. Photopolymerization initiator

As the photopolymerization initiator, a photo-radical polymerization initiator IRGACURE 651 available from Chiba Specialty Chemicals Co. , Ltd. was prepared.

### Organically treated phyllosilicate

### (1) Organically treated swellable mica

Interlaminar Na ions of a mica were replaced with a tetraalkyl ammonium compound. Thus, an organically treated swellable mica was prepared which had an average length of 5 µm, a thickness of 0.1 to 0.5 µm, an aspect ratio of 20 to 30 and an absolute specific gravity of 2.5.

### (2) Organically treated synthetic smectite

Exchangeable interlaminar cations (Na⁺, Mg²⁺, Li⁺ and the like) of a smectite were replaced with a tetraalkyl ammonium compound. Thus, an organically treated synthetic smectite was prepared which had a length of 0.1 to 2 µm, a thickness of 0.001 to 0.025 µm, an aspect ratio of 80 to 1000 and an absolute specific gravity of 2.7.

### Organically treated insulative spherical inorganic filler

### (1) Organically treated spherical silica α

First, 20 g of a spherical synthetic silica having a surface hydroxyl group concentration of 0.002 mmol/g, a specific surface area of 28.6 m²/g, an average particle diameter of 0.1 µm and a maximum particle diameter of 2 µm, 12.91 g of hexamethyldisilazane and 100 g of hexane were put in a glass flask provided with a cooling water pipe, and the resulting mixture was refluxed at about the boiling point of hexane (65°C to 69°C) for two hours. Thereafter, the resulting spherical synthetic silica was filtered out with the use of a paper filter, and dried at a reduced pressure at 40°C for 6 hours. Thus, an organically treated spherical silica α was provided. In the infrared absorption spectrum (FT-IR) of the organically treated spherical silica α, absorption was observed at a characteristic absorption band (about 2960 cm⁻¹) attributable to the methyl group.

### (2) Organically treated spherical silica β

First, 20 g of a spherical synthetic silica having a surface hydroxyl group concentration of 0.002 mmol/g, a specific surface area of 28.6 m²/g, an average particle diameter of 0.1 µm and a maximum particle diameter of 2 µm, 2.7 g of 3-acryloxypropyltrimethoxysilane, 100 g of methanol and 0.054 g of acetic acid were put in a glass flask provided with a cooling water pipe, and the resulting mixture was stirred at about a room temperature (22°C to 26°C) for 12 hours. Thereafter, the resulting spherical synthetic silica was filtered out with the use of a paper filter, and dried at a reduced pressure at 60°C for 12 hours in a shade. Thus, an organically treated spherical silica β was provided. In the infrared absorption spectrum (FT-IR) of the organically treated spherical silica β, absorption was observed at characteristic absorption bands (about 1620 cm⁻¹ and about 1720 cm⁻¹) attributable to the acryloyl group.

### (3) Organically treated spherical silica γ

First, 20 g of a spherical synthetic silica having a surface hydroxyl group concentration of 0.002 mmol/g, a specific surface area of 28.6 m²/g, an average particle diameter of 0.1 µm and a maximum particle diameter of 2 µm, 22.34 g of 2-isocyanatoethyl methacrylate, 100 g of toluene and 2.3 g of an ethyl acetate solution of 5 wt % dibutyltin laurate were put in a glass flask provided with a cooling water pipe, and a reaction was caused to proceed at 50°C for 6 hours in a shade. Thereafter, the resulting spherical synthetic silica was filtered out with the use of a paper filter, and dried at a reduced pressure at 60°C for 12 hours in a shade. Thus, an organically treated spherical silica γ was provided. In the infrared absorption spectrum (FT-IR) of the organically treated spherical silica γ, the absorption at a characteristic absorption band (about 2260 cm⁻¹) attributable to the isocyanate group was zero, and absorption was observed at characteristic absorption bands (about 1620 cm⁻¹ and about 1720 cm⁻¹) attributable to the acryloyl group.

### Example 1

The following components were prepared by the following methods (I-a), (I-b) and (II), and a dye-sensitized solar cell was assembled in the following manner (III).

### (I-a) Preparation of glass substrate having transparent electrically conductive electrode and glass substrate portion surface-coated with specific silane coupling agent to be brought into contact with seal member

A glass substrate (hereinafter sometimes referred to as "negative electrode substrate") (10 cm x 10 cm × 3 mm (thickness)) having an ITO transparent electrically conductive film and a titanium oxide semiconductor film provided on the ITO transparent electrically conductive film with L-4,4'-dicarboxy-2,2'-bipyridyl (N3 dye) adsorbed thereon was prepared. Then, a methanol solution of 1 wt% 3-acryloxypropyltrimethoxysilane was prepared, and applied onto a portion of the negative electrode substrate formed with the electrically conductive film to be brought into contact with a seal member, and dried at 100°C for 10 minutes. Thus, the glass substrate (negative electrode substrate) was prepared, which was subjected to the surface coating treatment with the silane coupling agent.

### (I-b) Preparation of metal oxide coated metal electrode substrate surface-coated with specific silane coupling agent

A metal titanium plate (10 cm × 10 cm × 0.5 mm (thickness)) was prepared as a positive electrode substrate to be opposed to the negative electrode substrate. The positive electrode substrate was fired at 600°C for 1 hour in a nitrogen stream, and then cooled to a room temperature (25°C) . Thus, a metal oxide film (titanium oxide film) having a thickness of 500 nm was formed in a surface of the metal titanium plate. The metal oxide film was substantially a tetravalent titanium oxide film. Then, a platinum vapor deposition film serving as a catalyst film (electrically conductive film) was formed on a portion of the positive electrode substrate to be generally opposed to the titanium oxide semiconductor film provided on the glass substrate with the dye adsorbed thereon. The methanol solution of 1 wt% 3-acryloxypropyltrimethoxysilane was applied onto a portion of the positive electrode substrate to be brought into contact with the seal member, and dried at 100°C for 10 minutes in the same manner as described above. Thus, the positive electrode substrate was prepared, which was subjected to the surface coating treatment with the silane coupling agent. The positive electrode substrate made of titanium was opaque.

Further, the methanol solution of 1 wt% 3-acryloxypropyltrimethoxysilane was applied onto thin glass pieces to be brought into contact with seal members, and dried at 150°C for 10 minutes. Thus, the thin glass pieces surface-coated with the silane coupling agent were prepared.

### (II) Preparation of specific photopolymerizable compos it ion (A) for seal members

A photopolymerizable composition (A) was prepared by blending 3g of the hydrogenated elastomer derivative (a), 7g of dimethyloldicyclopentane diacrylate (tricyclodecanedimethanol diacrylate) and 0.5 g of the photo-radical polymerization initiator.

### (III) Assembling of dye-sensitized solar cell

A main sealing operation was performed by applying the photopolymerizable composition (A) as a sealing material to a width of 5 mm and a thickness of 50 µm onto the portion of the glass substrate (negative electrode substrate) to be brought into contact with the seal member by means of a dispenser, bonding the positive electrode substrate and the negative electrode substrate to each other with their electrically conductive electrode surfaces facing inward and opposed to each other, and irradiating the applied photopolymerizable composition (A) with ultraviolet radiation (at 3 J/cm²) from the side of the glass substrate in a nitrogen stream. Thereafter, an acetonitrile solution containing 0.05 mol/L of iodine (electrolyte solution) was injected into a space defined between the electrode substrates bonded to each other in an opposed relationship through an opening (having a diameter of 1 mm) of the positive electrode substrate. Further, an end sealing operation was performed in substantially the same manner as described above for sealing by placing the thin glass pieces coated with the photopolymerizable composition (A) as the sealing material over the openings, and irradiating the photopolymerizable composition (A) with ultraviolet radiation (at 3 J/cm²) in a nitrogen stream. Thus, the intended dye-sensitized solar cell was assembled.

### Example 2

A dye-sensitized solar cell was assembled in substantially the same manner as in Example 1, except that a methanol solution of 3-methacryloxypropyltrimethoxysilane (having a concentration of 1 wt%) was used as the silane coupling agent instead of the 3-acryloxypropyltrimethoxysilane solution of Example 1 and applied onto the portion of the glass substrate (negative electrode substrate) to be brought into contact with the seal member.

### Example 3

A dye-sensitized solar cell was assembled in substantially the same manner as in Example 1, except that a photopolymerizable composition prepared by blending 7 g of the hydrogenated elastomer derivative (a), 3 g of dimethyloldicyclopentane diacrylate (tricyclodecanedimethanol diacrylate) and 0.5 g of the photo-radical polymerization initiator was used instead of the photopolymerizable composition (A) of Example 1.

### Example 4

A dye-sensitized solar cell was assembled in substantially the same manner as in Example 1, except that the hydrogenated elastomer derivative (b) was used instead of the hydrogenated elastomer derivative (a) in the photopolymerizable composition of Example 1.

### Example 5

A dye-sensitized solar cell was assembled in substantially the same manner as in Example 1, except that a photopolymerizable composition prepared by blending 5 g of the hydrogenated elastomer derivative (a), 3 g of 1,6-hexanediol diacrylate and 0.5 g of the photo-radical polymerization initiator was used instead of the photopolymerizable composition (A) of Example 1.

### Example 6

A dye-sensitized solar cell was assembled in substantially the same manner as in Example 1, except that the hydrogenated elastomer derivative (c) was used instead of the hydrogenated elastomer derivative (a) in the photopolymerizable composition of Example 1.

### Example 7

A dye-sensitized solar cell was assembled in substantially the same manner as in Example 1, except that the hydrogenated elastomer derivative (d) was used instead of the hydrogenated elastomer derivative (a) in the photopolymerizable composition of Example 1.

### Example 8

A dye-sensitized solar cell was assembled in substantially the same manner as in Example 7, except that a methanol solution of 1 wt% 3-methacryloxypropyltrimethoxysilane was used instead of the silane coupling agent used in Example 7 and applied onto the portion of the glass substrate (negative electrode substrate) to be brought into contact with the seal member.

### Example 9

A dye-sensitized solar cell was assembled in substantially the same manner as in Example 7, except that a photopolymerizable composition prepared by blending 7 g of the hydrogenated elastomer derivative (d), 3 g of dimethyloldicyclopentane diacrylate (tricyclodecanedimethanol diacrylate) and 0.5 g of the photo-radical polymerization initiator was used instead of the photopolymerizable composition (A) used in Example 7.

### Example 10

A dye-sensitized solar cell was assembled in substantially the same manner as in Example 7, except that the hydrogenated elastomer derivative (e) was used instead of the hydrogenated elastomer derivative (d) in the photopolymerizable composition used in Example 7.

### Example 11

A dye-sensitized solar cell was assembled in substantially the same manner as in Example 7, except that a photopolymerizable composition prepared by blending 7 g of the hydrogenated elastomer derivative (d), 3 g of 1,6-hexanediol diacrylate and 0.5 g of the photo-radical polymerization initiator was used instead of the photopolymerizable composition (A) used in Example 7.

### Example 2

A dye-sensitized solar cell was assembled in substantially the same manner as in Example 7, except that the hydrogenated elastomer derivative (f) was used instead of the hydrogenated elastomer derivative (d) in the photopolymerizable composition used in Example 7.

### Example 13

A dye-sensitized solar cell was assembled in substantially the same manner as in Example 1, except that a photopolymerizable composition prepared by adding 1 g of the organically treated swellable mice to the photopolymerizable composition (A) of Example 1 and milling the resulting mixture through a three-roll mill (having a roll gap of 0.1 µm) ten times was used instead of the photopolymerizable composition (A) used in Example 1.

### Example 14

A dye-sensitized solar cell was assembled in substantially the same manner as in Example 1, except that a photopolymerizable composition prepared by adding 15 g of the organically treated synthetic smectite to the photopolymerizable composition (A) of Example 1 and milling the resulting mixture through a three-roll mill (having a roll gap of 0.1 µm) ten times was used instead of the photopolymerizable composition (A) used in Example 1.

### Example 15

A dye-sensitized solar cell was assembled in substantially the same manner as in Example 1, except that a photopolymerizable composition prepared by adding 10 g of the organically treated spherical silica α to the photopolymerizable composition (A) of Example 1 and milling the resulting mixture through a three-roll mill (having a roll gap of 0.1 µm) ten times was used instead of the photopolymerizable composition (A) used in Example 1.

### Example 16

A dye-sensitized solar cell was assembled in substantially the same manner as in Example 1, except that a photopolymerizable composition prepared by adding 10 g of the organically treated spherical silica β to the photopolymerizable composition (A) of Example 1 and milling the resulting mixture through a three-roll mill (having a roll gap of 0.1 µm) ten times was used instead of the photopolymerizable composition (A) used in Example 1.

### Example 17

A dye-sensitized solar cell was assembled in substantially the same manner as in Example 1, except that a photopolymerizable composition prepared by adding 10 g of the organically treated spherical silica γ to the photopolymerizable composition (A) of Example 1 and milling the resulting mixture through a three-roll mill (having a roll gap of 0.1 µm) ten times was used instead of the photopolymerizable composition (A) used in Example 1.

### Comparative Example 1

A dye-sensitized solar cell was assembled in substantially the same manner as in Example 1, except that the portions of the positive electrode substrate and the negative electrode substrate to be brought into contact with the seal member were not subjected to any surface coating treatment.

### Comparative Example 2

A dye-sensitized solar cell was assembled in substantially the same manner as in Example 1, except that a methanol solution of 1 wt% 3-glycidoxypropyltrimethoxysilane was used instead of the silane coupling agent of Example 1 and applied onto the portions of the positive electrode substrate and the negative electrode substrate to be brought into contact with the seal member.

### Comparative Example 3

A dye-sensitized solar cell was assembled in substantially the same manner as in Example 1, except that the unsaturated elastomer derivative (g) was used instead of the hydrogenated elastomer derivative (a) in the photopolymerizable composition used in Example 1.

### Comparative Example 4

A dye-sensitized solar cell was assembled in substantially the same manner as in Example 7, except that the portions of the positive electrode substrate and the negative electrode substrate to be brought into contact with the seal member were not subjected to any surface coating treatment.

### Comparative Example 5

A dye-sensitized solar cell was assembled in substantially the same manner as in Example 7, except that a methanol solution of 1 wt% 3-glycidoxypropyltrimethoxysilane was used instead of the silane coupling agent of Example 7 and applied onto the portions of the electrode substrates to be brought into contact with the seal member.

### Comparative Example 6

A dye-sensitized solar cell was assembled in substantially the same manner as in Example 7, except that the unsaturated elastomer derivative (h) was used instead of the hydrogenated elastomer derivative (d) in the photopolymerizable composition used in Example 7.

The dye-sensitized solar cells thus obtained were allowed to stand in a thermostatic chamber at 80°C at 85 %RH (relative humidity) for 1000 hours (about 42 days) for test (in conformity with the environmental and endurance tests specified in JIS C8938). Then, endurance tests for liquid leakage and swelling were performed by the following methods. The results of the tests are shown below in Tables 1 and 2.

### Liquid leakage

An electrolyte solution filling area as seen from an upper side of the dye-sensitized solar cell was measured immediately after the assembling and after the test. An area percentage of the filling area measured after the test with respect to the filling area measured immediately after the assembling was determined, which was defined as an index of liquid leakage. Without the liquid leakage, the area percentage is 100%. The degree of the liquid leakage is increased as the area percentage decreases. This measurement is based on the fact that, if the electrolyte solution leaks, a space is correspondingly created in which the electrolyte solution is not present, and the electrolyte solution filling area after the test is smaller than that before the test.

### Swelling

If the electrolyte solution (containing iodine) permeates into the seal member in the assembled dye-sensitized solar cell, colorization with the iodine occurs transversely of the seal member (from the inside to the outside parallel to the substrates). Therefore, the width of the colorization with the iodine was measured, which was defined as an index of the swelling of the seal member with the electrolyte solution (based on the fact that the swelling occurs as a result of the permeation of the electrolyte solution). The swelling is less liable to occur when the width of the coloration is smaller. Since the width of the seal member is 5 mm at the maximum, the width of the coloration with the iodine is also 5 mm at the maximum.

**Table 1**

| | Liquid leakage (area: %) | Swelling (Coloration width: mm) |
|---|---|---|
| Example 1 | 97 | 0.3 |
| Example 2 | 96 | 0.2 |
| Example 3 | 95 | 1.0 |
| Example 4 | 95 | 0.3 |
| Example 5 | 95 | 0.4 |
| Example 6 | 99 | 0.2 |
| Example 7 | 100 | ≤0.05 |
| Example 8 | 100 | ≤0.05 |
| Example 9 | 95 | 2.2 |
| Example 10 | 100 | ≤0.05 |
| Example 11 | 95 | 1.2 |
| Example 12 | 98 | 0.3 |
| Example 13 | 99 | 0.2 |
| Example 14 | 99 | 0.3 |
| Example 15 | 100 | ≤ 0.05 |
| Example 16 | 99 | ≤ 0.05 |
| Example 17 | 99 | ≤ 0.05 |

**Table 2**

| | Liquid leakage (area: %) | Swelling (Coloration width: mm) |
|---|---|---|
| Comparative Example 1 | 0 | 5.0 (overall width) |
| Comparative Example 2 | 0 | 5.0 (overall width) |
| Comparative Example 3 | 20 | 5.0 (overall width) |
| Comparative Example 4 | 0 | 5.0 (overall width) |
| Comparative Example 5 | 0 | 5.0 (overall width) |
| Comparative Example 6 | 0 | 5.0 (overall width) |

The above results indicate that the products of the inventive examples were substantially free from the leakage of the electrolyte solution with a filling area percentage of 95% or greater as a result of the measurement of the liquid leakage. As a result of the measurement of the swelling, the products of Examples 3, 9 and 11, which had coloration widths of 1.0 mm, 2.2 mm and 1.2 mm, respectively, were practically acceptable. The products of the other inventive examples had little swelling with a coloration width of 0.4 mm or less. Therefore, the dye-sensitized solar cells of the inventive examples were excellent in sealing property.

On the other hand, the products of the comparative examples apparently suffered from the leakage of the electrolyte solution with a filling area percentage of 0 to 20 % as a result of the measurement of the liquid leakage. As a result of the measurement of the swelling, the products of the comparative examples disadvantageously suffered from significant swelling with a coloration width of 5.0 mm, which was the maximum coloration width (equal to the overall width).

Next, a dye-sensitized solar cell was produced by forming collector electrodes at a pitch of 5 mm on the electrically conductive electrode surface of the glass substrate of Example 1 formed with the transparent electrically conductive film, and evaluated in the aforementioned manner through measurement. As a result, the dye-sensitized solar cell was excellent in liquid leakage resistance and swelling resistance, like the dye-sensitized solar cells of the inventive examples described above. The formation of the collector electrodes and the covering protective members was achieved in the following manner. Collector electrode silver wirings (each having a width of 100 µm and a thickness of 5 µm) were formed on the electrically conductive electrode surface of the glass substrate by a screen printing method, and then fired at 600°C for 1 hour. Thus, the collector electrodes were formed. Thereafter, a glass paste (G3-4965 available from Okuno Chemical Industries Co., Ltd.) was applied to a thickness of 30 µm on the collector electrodes and portions of the substrate formed with the collector electrodes to be brought into contact with the covering protective members by a screen printing method, and fired at 550°C for 1 hour. Thus, glass surface-treated layers were formed. Then, the specific photopolymerizable composition of Example 1 was applied onto the glass surface-treated layers by a screen printing method, and then cured by irradiation with ultraviolet radiation emitted at 10 mW/cm² from a high pressure mercury lamp for 300 seconds in a nitrogen atmosphere. Thus, the covering protective members were formed for prevention of breakage and malfunction of the collector wirings due to the electrolyte solution.

Although specific forms of embodiments of the instant invention have been described above and illustrated in the accompanying drawings in order to be more clearly understood, the above description is made by way of example and not as a limitation to the scope of the instant invention. It is contemplated that various modifications apparent to one of ordinary skill in the art could be made without departing from the scope of the invention

In the inventive dye-sensitized solar cell, the seal member is composed of the material cured by photopolymerizing the specific photopolymerizable composition, which obviates the need for thermal curing. Therefore, the dye-sensitized solar cell is free from the separation of the seal member which may otherwise occur due to the evaporation of the electrolyte solution caused by the heating, and free from the swelling and the degradation with the electrolyte solution during prolonged sealing use. In addition, the synergetic effect of the aforementioned specific silane coupling agent on the glass substrate ensures higher adhesiveness and higher durability. Therefore, the present invention is widely applicable to dye-sensitized solar cells which particularly require durability to ensure higher reliability.

## Claims

1. A dye-sensitized solar cell, comprising:
a pair of electrode substrates, one of which is a metal electrode substrate and the other of which is a glass substrate having a transparent electrically conductive electrode film, the electrode substrates being spaced a predetermined distance from each other with an electrode surface of the metal electrode substrate and the transparent electrically conductive electrode film facing inward;
a seal member disposed along peripheries of inner surfaces of the electrode substrates to seal a space defined between the electrode substrates; and
an electrolyte solution filled in the sealed space;
wherein the metal electrode substrate is a metal oxide coated metal electrode substrate which has a surface coated with a metal oxide film;
wherein the seal member is composed of a material cured by photopolymerizing the following photopolymerizable composition (A) :
(A) a photopolymerizable composition comprising a hydrogenated elastomer derivative having at least one (meth)acryloyl group at at least one of its opposite molecular terminals;
wherein the metal oxide coated metal electrode substrate and the glass substrate each have a portion coated with a silane coupling agent of a (meth)acryloxyalkylsilane in contact with the seal member.

2. The dye-sensitized solar cell as set forth in claim 1, wherein the metal oxide coated metal electrode substrate is a metal oxide coated titanium substrate having an electrically conductive film formed of at least one of platinum and carbon on a surface thereof.

3. The dye-sensitized solar cell as set forth in claim 1 or 2, wherein the photopolymerizable composition (A) comprises a phyllosilicate.

4. The dye-sensitized solar cell as set forth in any one of claims 1 to 3, wherein the photopolymerizable composition (A) comprises an insulative spherical inorganic filler.

5. The dye-sensitized solar cell as set forth in any one of claims 1 to 4, wherein the (meth)acryloxyalkylsilane silane coupling agent is 3-(meth)acryloxypropyltrimethoxysilane.

6. The dye-sensitized solar cell as set forth in any one of claims 1 to 5, wherein the hydrogenated elastomer derivative of the photopolymerizable composition (A) comprises a hydrogenated polybutadiene in its main chain.

7. The dye-sensitized solar cell as set forth in any one of claims 1 to 5, wherein the hydrogenated elastomer derivative of the photopolymerizable composition (A) comprises a hydrogenated polyisoprene in its main chain.

8. The dye-sensitized solar cell as set forth in any one of claims 1 to 6 wherein the hydrogenated elastomer derivative of the photopolymerizable composition (A) is a hydrogenated polybutadiene derivative obtained through a reaction between a hydrogenated polybutadiene polyol and a hydroxy(meth)acrylate compound by using a polyisocyanate as a linking group.

9. The dye-sensitized solar cell as set forth in any one of claims 1 to 5 and 7, wherein the hydrogenated elastomer derivative of the photopolymerizable composition (A) is a hydrogenated polyisoprene derivative obtained through a reaction between a hydrogenated polyisoprene polyol and a hydroxy(meth)acrylate compound by using a polyisocyanate as a linking group.

10. The dye-sensitized solar cell as set forth in any one of claims 1 to 6 and 8, wherein the hydrogenated elastomer derivative of the photopolymerizable composition (A) is the following component (a1), and the photopolymerizable composition (A) further comprises the following components (b), (c) and (d):
(a1) a hydrogenated polybutadiene derivative obtained through a reaction between a hydrogenated polybutadiene polyol and a hydroxy(meth)acrylate compound by using a polyisocyanate as a linking group;
(b) a poly(meth)acrylate compound;
(c) a photopolymerization initiator; and
(d) at least one of a phyllosilicate and an insulative spherical inorganic filler.

11. The dye-sensitized solar cell as set forth in any one of claims 1 to 5,7 and 9, wherein the hydrogenated elastomer derivative of the photopolymerizable composition (A) is the following component (a2), and the photopolymerizable composition (A) further comprises the following components (b), (c) and (d):
(a2) a hydrogenated polyisoprene derivative obtained through a reaction between a hydrogenated polyisoprene polyol and a hydroxy(meth)acrylate compound by using a polyisocyanate as a linking group;
(b) a poly(meth)acrylate compound;
(c) a photopolymerization initiator; and
(d) at least one of a phyllosilicate and an insulative spherical inorganic filler.

12. The dye-sensitized solar cell as set forth in any one of claims 1 to 6, wherein the hydrogenated elastomer derivative of the photopolymerizable composition (A) is a hydrogenated polybutadiene derivative obtained through a reaction between a hydrogenated polybutadiene polyol and a (meth)acryloyl-containing isocyanate compound.

13. The dye-sensitized solar cell as set forth in any one of claims 1 to 5 and 7, wherein the hydrogenated elastomer derivative of the photopolymerizable composition (A) is a hydrogenated polyisoprene derivative obtained through a reaction between a hydrogenated polyisoprene polyol and a (meth)acryloyl-containing isocyanate compound.

14. The dye-sensitized solar cell as set forth in any one of claims 1 to 6, wherein the hydrogenated elastomer derivative of the photopolymerizable composition (A) is the following component (a3), and the photopolymerizable composition (A) further comprises the following components (b), (c) and (d):
(a3) a hydrogenated polybutadiene derivative obtained through a reaction between a hydrogenated polybutadiene polyol and a (meth)acryloyl-containing isocyanate compound;
(b) a poly(meth)acrylate compound;
(c) a photopolymerization initiator; and
(d) at least one of a phyllosilicate and an insulative spherical inorganic filler.

15. The dye-sensitized solar cell as set forth in any one of claims 1 to 5 and 7, wherein the hydrogenated elastomer derivative of the photopolymerzable composition (A) is the following component (a4), and the photopolymerizable composition (A) further comprises the following components (b), (c) and (d):
(a4) a hydrogenated polyisoprene derivative obtained through a reaction between a hydrogenated polyisoprene polyol and a (meth)acryloyl-containing isocyanate compound;
(b) a poly(meth)acrylate compound;
(c) a photopolymerization initiator; and
(d) at least one of a phyllosilicate and an insulative spherical inorganic filler.

16. The dye-sensitized solar cell as set forth in any one of claims 1 to 15, wherein the metal oxide film of the metal oxide coated metal electrode substrate contains a titanium element having a valence of not less than 4 in a proportion of not less than 95 wt%.

17. The dye-sensitized solar cell as set forth in any one of claims 1 to 16, wherein the metal oxide film of the metal oxide coated metal electrode substrate is a tetravalent titanium oxide film, which has a thickness of not less than 50 nm.

18. The dye-sensitized solar cell as set forth in any one of claims 1 to 17, further comprising a collector electrode provided on an inner surface of at least one of the metal oxide coated metal electrode substrate and the glass substrate having the transparent electrically conductive electrode film.
